# EUROPEAN PATENT APPLICATION

(11) **EP 2 037 491 A1**
(43) Date of publication of application: **18.03.2009**
(21) Application number: 07767356.4
(22) Date of filing: 21.06.2007
(51) Int. Cl.: H01L 21/285, C23C 16/42, H01L 21/28, H01L 29/423, H01L 29/49, H01L 29/78

(54) **METHOD OF FORMING TaSiN FILM**

(30) Priority: 21.06.2006 JP 2006171862
(71) Applicant: Tokyo Electron Limited, Tokyo 107-8481 (JP)
(72) Inventor: NAKAMURA, Kazuhito, Nagoya-shi, Aichi 4550042 (JP); YAMASAKI, Hideaki, Nirasaki-shi, Yamanashi 4070192 (JP); KAWANO, Yumiko, Nirasaki-shi, Yamanashi 4070192 (JP)
(74) Representative: HOFFMANN EITLE
(86) International application number: PCT/JP2007/062530
(87) International publication number: WO 2007/148760

(57) **Abstract**

A substrate is disposed in a processing chamber. An organic Ta compound gas having Ta=N bond, a Si-containing gas and a N-containing gas are introduced into the processing chamber to form a TaSiN film on the substrate by CVD. In this film formation, at least one of a partial pressure of the Si-containing gas in the processing chamber, a total pressure in the processing chamber, a film forming temperature and a partial pressure of the N-containing gas in the processing chamber is controlled to thereby regulate Si concentration in the film. Particularly, when SiH₄ gas is used as the Si-containing gas, the SiH₄ gas partial pressure is determined based on the fact that the serried Si concentration in the film under giving process conditions can be expressed as a linear function involving the logarithm of the partial pressure of the SiH₄ gas.

## Description

### Field of the Invention

The present invention relates to a method for forming a TaSiN film which is preferable as a gate electrode by using a CVD (chemical vapor deposition) method.

### Background of the Invention

Conventionally, a TaSiN film is used as a gate electrode, a reaction barrier layer of a poly silicon film formed on the gate electrode, a contact barrier film, a barrier film of Al, Cu or the like of wiring portions and an underlying film, and is formed by thermal CVD (see, e.g., Japanese Patent Laid-open Publication Nos. 2003-332426 and 2005-244178).

Recently, it has been studied to use a TaSiN film as a metal electrode material of a gate electrode in a MOS semiconductor device. In this case, it is expected that Si concentration in the film influences work function. Accordingly, it is considered that a desired work function can be obtained by controlling the Si concentration. However, in case of a conventional barrier film, Si concentration in the film is not considered and the aforementioned publications do not disclose about Si concentration. Further, conventionally, there has been found no parameter that can control Si concentration to a high level, so that a TaSiN film having a high Si concentration of 20 atomic% or more cannot be obtained.

### Summary of the Invention

In view of the above, the present invention provides a method for forming a TaSiN film by CVD which is capable of controlling Si concentration in a wide range with high accuracy.

Further, the present invention provides a method for forming a TaSiN film having a high Si concentration by using a CVD method.

Moreover, the present invention provides a computer readable storage medium for executing the TaSiN film forming method.

In accordance with a first aspect of the present invention, there is provided a TaSiN film forming method including: disposing a substrate in a processing chamber; and introducing a gas of an organic Ta compound having Ta=N bond, a Si-containing gas and a N-containing gas into the processing chamber to form a TaSiN film on the substrate by CVD, wherein Si concentration in the film is controlled by controlling at least one of a partial pressure of the Si-containing gas in the processing chamber, a total pressure in the processing chamber, a film forming temperature and a partial pressure of the N-containing gas in the processing chamber.

In the first aspect, SiH₄ gas and NH₃ gas may be preferably used as the si-containing gas and the N-containing gas, respectively. In this case, preferably, the film forming temperature is set to 350 to 700°C, the total pressure in the processing chamber is set to 1.33 to 1333 Pa (0.01 to 10 Torr), the partial pressure of the SiH₄ gas is set to 0.4 to 66.5 Pa (0.003 to 0.5 Torr) or 1% to 80% of the total pressure, the partial pressure of the NH₃ gas is set to 0.1 to 39.9 Pa (0.001 to 0.3 Torr) or 0.3% to 30% of the total pressure. Further, preferably, a flow rate of the SiH₄ gas is set to 10 to 1000 mL/min (sccm), a flow rate of the NH₃ gas is set to 1000 mL/min (sccm) or less, a flow rate Ar gas as a carrier gas for generating the organic Ta compound gas from the organic Ta compound is set to 10 to 200 mL/min (sccm), a flow rate of Ar gas as a dilution gas is set to 10 to 1000 mL/min (sccm).

Moreover, when the film forming temperature is set to 600°C and the total pressure in the processing chamber is set to 40 Pa (0.3 Torr), the Si concentration in the film is controlled based on a relationship of y = 0.64 × log x + 1.69 where x is the SiH₄ gas partial pressure (Torr) and y is a ratio of (Si atom number)/(Ta atom number) in the film. Further, when the film forming temperature is set to 600°C and the total pressure in the processing chamber is set to 6.7 Pa (0.05 Torr), the Si concentration in the film is controlled based on a relationship of y = 0.46 × log x + 1.58 where x is the SiH₄ gas partial pressure (Torr) and y is a ratio of (Si atom number)/(Ta atom number) in the film.

In accordance with a second aspect of the present invention, there is provided a TaSiN film forming method including: disposing a substrate in a processing chamber; and introducing a gas of an organic Ta compound having Ta=N bond, SiH₄ gas and NH₃ gas into the processing chamber to form a TaSiN film on the substrate by CVD, wherein a film forming temperature is set to 600°C or higher, a film forming pressure is set to 20 Pa (0.15 Torr) or greater, a partial pressure of the SiH₄ gas is set to 6.7 Pa (0.05 Torr) or greater or 5% or greater of a total pressure in the processing chamber.

In the second aspect, preferably, a partial pressure of the NH₃ gas is also set to 13.3 Pa (0.1 Torr) or less or 30% or less of the total pressure in the processing chamber.

In accordance with a third aspect of the present invention, there is provided a computer readable storage medium storing therein a control program for controlling a film forming apparatus, wherein when the control program is executed on a computer, the film forming apparatus is controlled by the computer to perform the film forming method of the first or second aspect.

In accordance with the present invention, in forming the TaSiN film by CVD, conditions influencing Si concentration have been defined clearly, so that Si concentration in the TaSiN film can be controlled with high accuracy in a wide range. Further, by properly selecting the conditions influencing Si concentration, a TaSiN film having a high Si concentration of 20 atomic% or greater can be obtained.

### Brief Description of the Drawings

Fig. 1 is a schematic cross sectional view of a film forming apparatus for performing a TaSiN film method in accordance with an embodiment of the present invention.
Fig. 2 is a graph showing a relationship between a ratio of Ta/Si and Si concentration in a TaSiN film.
Fig. 3 is a graph showing a relationship between a partial pressure (Torr) of SiH₄ gas and Si/Ta with respect to a standard condition, a low pressure condition, a low temperature condition and a low NH₃ gas partial pressure condition.
Fig. 4 is a graph showing a relationship between a partial pressure of SiH₄ gas and Si concentration in the film.
Fig. 5 is a graph showing a relationship between a partial pressure of NH₃ gas and Si concentration in the film.
Fig. 6 is a graph showing a relationship between a ratio of SiH₄ gas partial pressure/NH₃ gas partial pressure and Si concentration in the film.
Fig. 7 is a graph showing a relationship between a film forming temperature and Si concentration in the film.
Fig. 8 shows a cross sectional view of an application example of a TaSiN film formed in accordance with the present invention.
Fig. 9 shows a cross sectional view of another application example of a TaSiN film formed in accordance with the present invention.
Fig. 10 is a graph showing a relationship between C concentration and Si concentration in the film and a work function.

### Detailed Description of the Embodiment

An embodiment of the present invention will be described with reference to the accompanying drawings in detail.

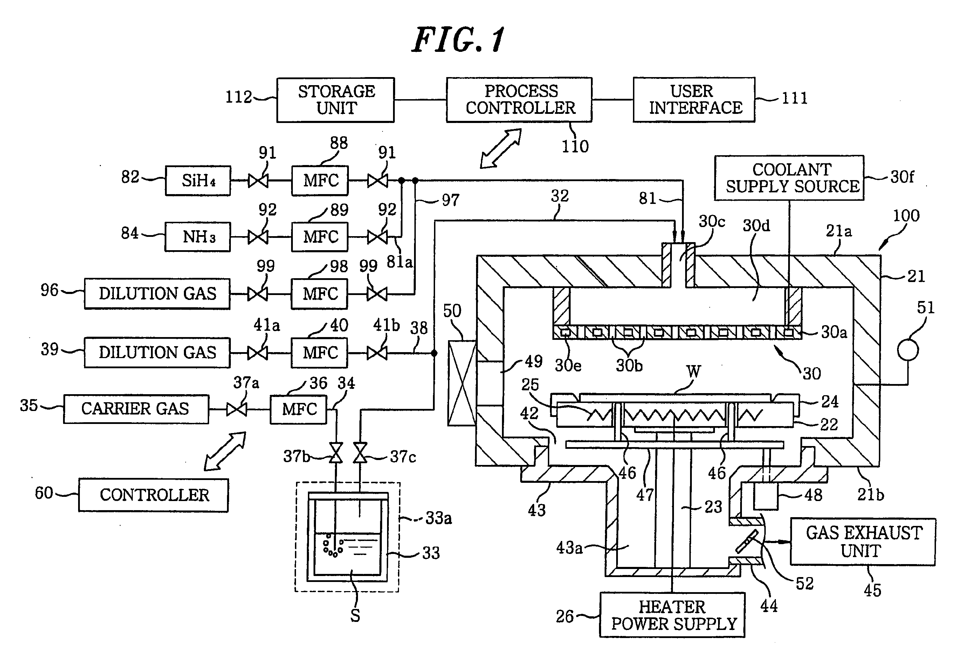

First, the embodiment of the present invention will be described. Fig. 1 shows a schematic cross sectional view of a film forming apparatus for performing a TaSiN film forming method in accordance with the embodiment of the present invention.

The film forming apparatus 100 includes a substantially cylindrical chamber 1 that is airtightly sealed.

A circular opening 42 is formed at a substantially central portion of a bottom wall 21b of the chamber 21, and a gas exhaust chamber 43 projecting downward is provided on the bottom wall 21b to communicate with the opening 42. A susceptor 22 made of ceramic, e.g., AlN or the like, is provided in the chamber 1 to horizontally support a wafer W that is a semiconductor substrate. The susceptor 22 is supported by a cylindrical supporting member 23 extending upward from a central bottom portion of the gas exhaust chamber 43. A guide ring 24 for guiding the wafer W is provided on an outer edge portion of the susceptor 22.

Further, a resistance heater 25 is buried in the susceptor 22. The resistance heater 25 heats the susceptor 22 by being supplied with power from a heater power supply 26 and the wafer W is heated by heat thus generated. With such heat, Ta source gas introduced into the chamber 21 is thermally decomposed as will be described later. The heater power supply 26 is connected to a controller (not shown), and the controller controls the output of the heater 25 in accordance with a signal from a temperature sensor (not shown). Furthermore, a heater (not shown) is embedded in a wall of the chamber 21 to heat the wall of the chamber 21 to about 40 to 200°C.

The susceptor 22 is provided with three wafer supporting pins 46 (only two shown) for supporting and moving the wafer W up and down. The wafer supporting pins 46 can be protruded from and retracted into the top surface of the susceptor 22 and are fixed to a supporting plate 47. The wafer supporting pins 46 are moved up and down by a driving mechanism 48 such as an air cylinder through the supporting plate 47.

A shower head 30 is provided on a ceiling wall 21a of the chamber 21. Installed under the shower head 30 is a shower plate 30a having a plurality of gas injection openings 30b for injecting a gas toward the susceptor 22. A gas inlet port 30c for introducing a gas into the shower head 30 is installed on an upper wall of the shower head 30, and is connected with a line 32 for supplying Ta source gas and a line 81 for supplying a Si-containing gas, e.g., SiH₄ gas and a N-containing gas, e.g., NH₃ gas. In addition, a diffusion space 30d is formed inside the shower head 30. The shower plate 30a is provided with, e.g., a concentrically arranged coolant channel 30e, in order to prevent the decomposition of the Ta source gas in the shower head 30. By supplying a coolant such as cooling water, Galden (registered trademark) or the like from a coolant supply source 30f to the coolant channel 30e, a temperature of the shower head 30 can be controlled to about 20 to 200°C.

The other end of the line 32 is inserted into the Ta source container 33 having therein Ta source material S as an organic Ta compound. A heater 33a as a heating unit is provided around the Ta source container 33. A carrier gas line 34 is inserted into the Ta source container 33. By supplying a carrier gas, e.g., Ar gas, from a carrier gas supply source 35 to the Ta source container 33 via the line 34, the Ta source material S as the organic Ta compound in the Ta source container 33 is heated and vaporized into Ta source gas by the heater 33a. The Ta source gas is carried by the carrier gas into the diffusion space 30d in the chamber 21 via the line 32. As the carrier gas, N₂ gas, H₂ gas, He gas or the like may be used.

Moreover, a mass flow controller 36 is installed in the line 34, and valves 37a and 37b are respectively disposed at upstream and downstream sides of the mass flow controller 36. A heater (not shown) is disposed around the lines 32, 34, and is controlled to heat the lines at a temperature where the Ta source gas is not liquidized, e.g., about 40 to 200° C.

As the Ta source material S, in terms of chemical stability, there is used a material having Ta=N bond (double bond), e.g., Ta(Nt-Am)(Nme₂)₃ which has the following chemical formula.

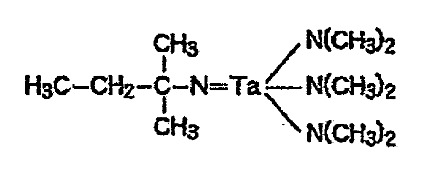

Moreover, one end of a dilution gas line 38 is connected to the line 32 and the other end of the dilution gas line 38 is connected to a dilution gas supply source 39. The dilution gas supply source 39 supplies, e.g., H₂ gas or an inert gas such as Ar gas, He gas, N₂ gas or the like, as a dilution gas. The Ta source gas is diluted by the dilution gas. The dilution gas is also used as a purge gas for exhausting a film forming gas remaining in the line 32 and purging the inside of the chamber 21. Further, a mass flow controller 40 is installed in the dilution gas line 38, and valves 41a and 41b are disposed at upstream and downstream sides of the mass flow controller 40.

Meanwhile, the other end of the line 81 is connected to a Si-containing gas supply source 82 for supplying, e.g., SiH₄ gas. The gas line 81 is provided with a mass flow controller 88 and valves 91 disposed at upstream and downstream sides of the mass flow controller 88.

One ends of a N-containing gas line 81a and a dilution gas line 97 are connected to the line 81. The other ends of the N-containing gas line 81a and the dilution gas line 97 are respectively connected to a N-containing gas supply source 84 for supplying, e.g., NH₃ gas and a dilution gas supply source 96 for supplying, e.g., Ar gas. As the dilution gas, an inert gas such as He gas or N₂ gas may be used. The Si-containing gas and the N-containing gas are diluted by the dilution gas. The dilution gas is also used as a purge gas for exhausting a film forming gas remaining in the line 81 and purging the inside of the chamber 21. A mass flow controller 89 is installed in the N-containing gas line 81a, and valves 92 are disposed at upstream and downstream sides of the mass flow controller 89. Further, a mass flow controller 98 is installed in the dilution gas line 97, and valves 99 are disposed at upstream and downstream sides of the mass flow controller 98.

The dilution gases are used to adjust partial pressures of the Ta source gas, the Si-containing gas and the N-containing gas, and to obtain a good in-plane uniformity in a film being formed by injecting the Ta source gas with an increased inner pressure of the shower head 30. The dilution gases are used as desired.

The mass flow controllers and the valves are controlled by a controller 60. Accordingly, the supply and stop of the carrier gas, the Ta source gas, the Si-containing gas (SiH₄ gas), the N-containing gas (NH₃ gas) and the purge gas, and flow rates thereof are controlled to the predetermined flow rates. The flow rate of the Ta source gas supplied to the gas diffusion space 30d in the chamber 21 is controlled by controlling the flow rate of the carrier gas by the mass flow controller 36.

A gas exhaust line 44 is connected to a side of the gas exhaust chamber 43. A gas exhaust unit 45 having a high speed vacuum pump is connected to the gas exhaust line 44. By operating the gas exhaust unit 45, the gas in the chamber 21 is uniformly discharged into the space 43a of the gas exhaust chamber 43, so that the inside of the chamber 21 can be depressurized up to a predetermined vacuum level at a high speed via the gas exhaust line 44. Provided at the chamber 21 is a pressure gauge 51 for measuring a pressure in the chamber 21, and an auto pressure valve controller (APC) 52 is provided in the gas exhaust line 44. The APC 52 is controlled based on the measurement value of the pressure gauge 51 to control the pressure in the chamber 21 to a predetermine level.

Provided on a sidewall of the chamber 21 are a loading/unloading port 49 for performing loading and unloading of the wafer W between the chamber 21 and a transfer chamber (not shown) adjacent to the film forming apparatus 100 and a gate valve 50 for opening and closing the loading/unloading port 49.

Each component of the film forming apparatus 100 is connected with a process controller 110 having a micro processor (computer) to be controlled thereby. The process controller 110 controls the valves and the like through the controller. The process controller 110 is connected with a user interface 111 having a keyboard, a display and the like. A process operator uses the keyboard when inputting commands for managing the film forming apparatus 100, and the display is used to display the operation status of the film forming apparatus 100.

Further, the process controller 110 is connected with a storage unit 112 for storing therein control programs for implementing various processes in the film forming apparatus 100 under the control of the process controller 110, programs or recipes for operating each component of the film forming apparatus based on the processing conditions. The recipes may be stored in a hard disk or a semiconductor memory, or may be set in a section of the storage unit 112 while being stored in a portable storage medium such as a CD-ROM or a DVD. In addition, the recipes may be transmitted properly from another device via, e.g., a dedicated line.

If necessary, the process controller 110 executes a recipe read from the storage unit 112 in response to instructions from the user interface 111, so that the film forming apparatus 100 performs a required process under the control of the process controller 110.

Hereinafter, there will be described a film forming method in accordance with the present embodiment using the film forming apparatus described above.

First, the gate valve 50 is opened and the wafer W having on its surface a gate insulating film is loaded through the loading/unloading port 49 into the chamber 21 to be mounted on the susceptor 22. The susceptor 22 is heated by the heater 25 in advance, and the wafer W is heated by the heated susceptor 22. The vacuum pump of the gas exhaust unit 45 evacuates the chamber 21 to decrease the pressure in the chamber 21 to 6.7 Pa or less.

Next, the valves 92 are opened and, for example, NH₃ gas as the N-containing gas from the N-containing gas supply source 84 is introduced into the chamber 21 through the line 81 and the shower head 30. At this time, as desired, for example, Ar gas as the dilution gas from the dilution gas supply source 96 is introduced into the chamber 21 through the line 81 and the shower head 30.

Thereafter, the valves 91 are opened and, for example, SiH₄ gas as the Si-containing gas from the Si-containing gas supply source 82 is introduced into the chamber 21 through the line 81 and the shower head 30.

Further, at the same time of the supply of the Si-containing gas, by opening the valves 37a and 37b, for example, Ar gas as the carrier gas from the carrier gas supply source 35 is blown into the Ta source container 33 containing, e.g., Ta(Nt-Am)(Nme₂)₃ having Ta=N bond (double bond) as the Ta source material S while the Ta source material is heated by the heater 33a to be vaporized. Then, the valve 37c is opened and the generated Ta source gas is carried by the carrier gas to be introduced into the chamber 21 through the line 32 and the shower head 30. At this time, for example, Ar gas as the dilution gas is also supplied into the chamber 21 from the dilution gas supply source 39.

In this way, the Ta source gas, the Si-containing gas (SiH₄ gas) and the N-containing gas (NH₃ gas) are reacted with each other on the wafer W to form TaSiN on the surface of the wafer W. Further, by supplying these gases for a predetermined time, a TaSiN film having a specific thickness is formed. In this case, although it is preferable in terms of uniformity and stability of the composition that the N-containing gas is first introduced into the chamber 21 as described above, the Ta source gas, the Si-containing gas and the N-containing gas may be introduced at the same time into the chamber 21.

Furthermore, since a C-containing organic Ta compound such as Ta(Nt-Am)(Nme₂)₃ or Ta(Nt-Bu)(NEt₂)₃ is used as the Ta source material and oxygen exists in the ambience, a little amount of O and C are contained in the film. It is preferable to suppress the amount of O and C to an extremely small level.

After formation of the film, the supply of the carrier gas, the Si-containing gas and the N-containing gas is stopped and the insides of the lines and the chamber 21 are purged by using the dilution gas. Then, the wafer W on the susceptor 22 is unloaded from the chamber 21.

In a case where a TaSiN film is used as a gate electrode, it is expected that Si concentration in the film influences work function, so that it is very important to change Si concentration in the film between a low concentration of about 5 atomic% and a high concentration of about 25 atomic%. Conventionally, the TaSiN film is largely used as a barrier layer, so that the TaSiN film is evaluated good if it has a desired barrier property. Si concentration in the film itself is not considered. Accordingly, when the TaSiN film is formed by using an organic Ta compound having Ta=N bond (double bond) which has a high chemical stability and is industrially advantageous, Si concentration in the film is inevitably decreased to 20 atomic% or less. Moreover, as a matter of course, any parameter for controlling Si concentration is not considered.

In forming the TaSiN film by using an organic Ta compound having Ta=N bond (double bond) as the Ta source material, the present invention defines conditions that Si-concentration in the film can be controlled and increased to about 25 atomic% so as to make the TaSiN film applicable to a gate electrode of MOS semiconductor. If Si concentration is increased, a sheet resistance is increased. Accordingly, it is not effective to use the TaSiN film having a high Si concentration as a barrier layer.

Specifically, by controlling at least one of a partial pressure of the Si-containing gas (SiH₄ gas), a film forming pressure (total pressure in the chamber), a film forming temperature (temperature of the susceptor) and a partial pressure of the N-containing gas (NH₃ gas), Si concentration in the film can be controlled within a range of about 11 to 25 atomic%. Particularly, by increasing the partial pressure of the Si-containing gas (SiH₄ gas), increasing the film forming temperature and decreasing the partial pressure of the N-containing gas (NH₃ gas), Si concentration in the film can be increased. Further, in a region where the partial pressure of the Si-containing gas (SiH₄ gas) is high, as the film forming pressure (total pressure in the chamber) is increased, Si concentration in the film can be increased.

Preferable film forming conditions are as follows.

Film forming temperature (susceptor temperature): 350-700°C, more preferably 500-700°C

Film forming pressure: 1.33-1333 Pa (0.01-10 Torr), more preferably 6.65-66.5 Pa (0.05-0.5 Torr)

Flow rate of carrier gas (Ar gas): 10-200 mL/min (sccm), preferably 50-150 mL/min (sccm)

Total flow rate of dilution gases (Ar gas): 10-1000 mL/min (sccm), preferably 50-300 mL/min (sccm)

Flow rate of Si-containing gas (SiH₄ gas): 10-1000 mL/min (sccm), preferably 300-700 mL/min (sccm)

Flow rate of N-containing gas (NH₃ gas): 1000 mL/min (sccm) or less, preferably 200 mL/min (sccm) or less

Partial pressure of Si-containing gas (SiH₄ gas): 0.4-66.5 Pa (0.003-0.5 Torr), preferably 6.7-66.5 Pa (0.05-0.5 Torr), or 1-80% of the total pressure, preferably 5-80% of the total pressure

Partial pressure of N-containing gas (NH₃ gas): 0.1-39.9 Pa (0.001-0.3 Torr), preferably 0.1-13.3 Pa (0.001-0.1 Torr), or 0.3-30% of the total pressure, preferably 0.3-10% of the total pressure

Furthermore, in the case where an organic Ta compound having Ta=N bond is used as the Ta source material, SiH₄ gas is used as the Si-containing gas and NH₃ gas is used as the N-containing gas, in order to obtain Si concentration of 20 atomic% or more, it is preferable to set the film forming temperature (susceptor temperature) to 600°C or higher, the film forming pressure to 20 Pa (0.15 Torr) or greater, and the partial pressure of SiH₄ gas to 6.78 Pa (0.05 Torr) or greater or 5% or more of the total pressure. In addition to the above, it is preferable to set the partial pressure of NH₃ gas to 13.3 Pa (0.1 Torr) or less or 30% or less of the total pressure.

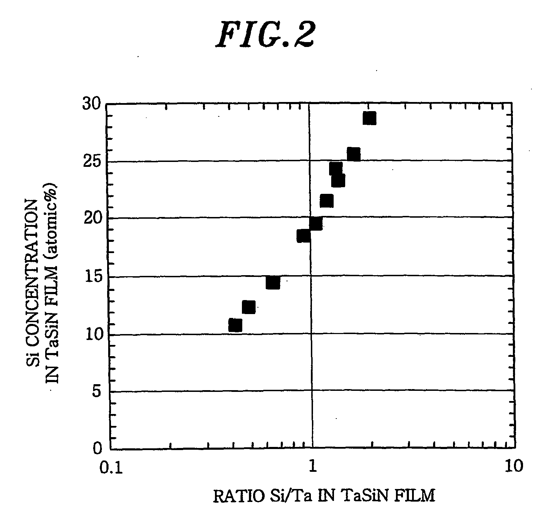

Si concentration can be obtained by X-ray photoelectron spectroscopy (XPS). As shown in Fig. 2, since Si concentration is proportional to a ratio of (Si atom number)/(Ta atom number), Si concentration can be calculated based on the ratio of (Si atom number)/(Ta atom number). The influence of sputter rate in the XPS analyzing in the depth direction is corrected by the measurement of Rutherford backscattering spectroscopy (RBS).

Next, a TaSiN film having a high Si concentration was actually obtained under the exemplary following conditions.

First, NH₃ gas was supplied together with Ar dilution gas into the chamber 21 via the shower head 30. Then, Ta(Nt-Am)(Nme₂)₃, an organic Ta compound having Ta=N bond, was inputted as Ta source material in the Ta source container 33 and heated to 47°C. Ta(Nt-Am)(Nme₂)₃ gas was carried by Ar dilution gas to be supplied together with SiH₄ gas onto the wafer W in the chamber 21 via the shower head 30.

The conditions were as follows.
Film forming temperature (susceptor temperature): 600°C
Film forming pressure: 40 Pa (0.3 Torr)
Ar carrier gas flow rate: 100 mL/min (sccm)
Ar dilution gas flow rate: 280 mL/min (sccm)
SiH₄ gas flow rate: 400 mL/min (sccm)
NH₃ gas flow rate: 20 mL/min (sccm)

A film having a thickness of 50 nm was formed for 300 seconds under the above conditions. As a result of measuring Si in the film as described above, Si concentration was 24.7 atomic% and the ratio of Si/Ta (atom number ratio) was 1.37.

Next, there will be described an example of controlling Si concentration in the film by changing the film forming conditions when a TaSiN film is formed.

In the apparatus shown in Fig. 1, the susceptor 22 was heated to 600°C in advance and a 300 mm wafer was mounted on the susceptor 22 by the transfer unit. In this state, a TaSiN film was formed under the following conditions.
Ar carrier gas flow rate: 40 mL/min (sccm)
Ar dilution gas flow rate: 40 mL/min (sccm)
SiH₄ gas flow rate: 500 mL/min (sccm)
NH₃ gas flow rate: 200 mL/min (sccm)
Film forming pressure (total pressure in chamber): 40 Pa
Film forming time: 300 seconds

The thickness of the film was 42 nm when measuring it by a scanning electron microscope (SEM). Further, as a result of analyzing the composition of the film, O : N : C : Si : Ta was 5.8 : 38.9 : 4.6 : 18.2 : 32. 5 (atomic%). By measuring the same sample also with RBS to correct the influence of scatter rate in the XPS in the depth direction, a ratio of Si/Ta (atom number ratio) was 1.22. At this time, a partial pressure of SiH₄ gas corresponds to 27 Pa (0.2 Torr).

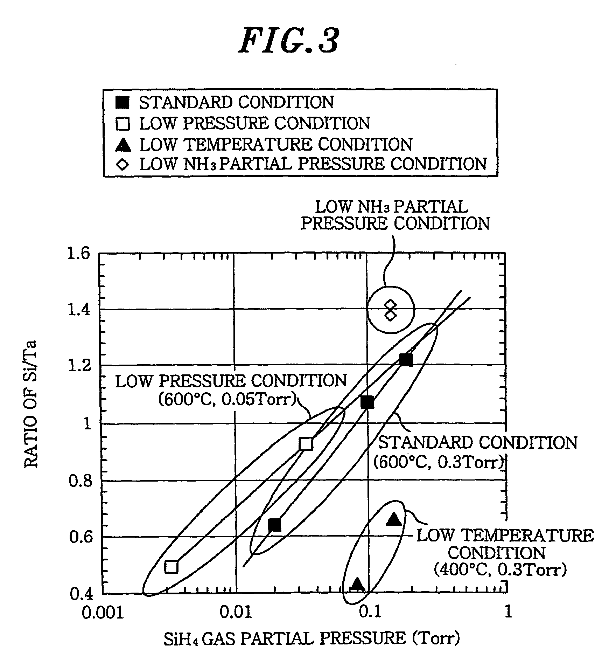

In the aforementioned conditions, under a condition (standard condition) that the film forming temperature was 600°C and the film forming pressure (total pressure in the chamber) was 40 Pa (0.3 Torr), a ratio of Si/Ta (atom number ratio) was obtained similarly by changing the flaw rate (partial pressure) of SiH₄ gas. In this specification, the Si/Ta ratio means the atom number ratio. Further, under a condition (low pressure condition) that the film forming pressure was decreased to 6.7 Pa (0.05 Torr) while the film forming temperature was set at 600°C, a Si/Ta ratio was obtained similarly by changing the flaw rate (partial pressure) of SiH₄ gas. Also, under a condition (low temperature condition) that the film forming temperature was decreased to 40°C while the film forming pressure was set at 40 Pa (0.3 Torr), a Si/Ta ratio was obtained similarly. In addition, in a state that the film forming temperature was set at 600°C and the film forming pressure (total pressure in the chamber) was set at 40 Pa (0.3 Torr), under a condition (low NH₃ gas partial pressure condition) that the partial pressure of NH₃ gas was decreased from 10.2 Pa (0.077 Torr) to 2.5 Pa (0.019 Torr) and 1.1 Pa (0.0008 Torr). The results are indicated in Fig. 3. Fig. 3 is a graph showing a relationship between the SiH₄ gas partial pressure (Torr) and the Si/Ta ratio wherein the former is represented (in logarithm) on the horizontal axis and the latter is on the vertical axis. With respect to plots in the standard condition and the low pressure condition, when taking "x" as the SiH₄ gas partial pressure and "y" as the Si/Ta ratio, a regression equation y = 0.64 × log x + 1.69 is obtained in case of the standard condition and a regression equation y = 0.46 x log x + 1.58 is obtained in case of the low pressure condition. In either case, as the SiH₄ gas partial pressure (flow rate) is increased, the Si/Ta ratio, i.e., Si concentration in the film, is increased. When the SiH₄ gas partial pressure is less than 0.15 Torr (20 Pa), under a same SiH₄ gas partial pressure, the Si/Ta ratio is increased as the film forming pressure (total pressure in the chamber) is decreased. When the SiH₄ gas partial pressure is greater than 0.15 Torr (20 Pa), under a same SiH₄ gas partial pressure, the Si/Ta ratio is increased as the film forming pressure (total pressure in the chamber) is increased. By determining the SiH₄ gas partial pressure using the above relationships, it is possible to control Si concentration in the TaSiN film with high accuracy.

Furthermore, with respect to the film forming temperature, it can be seen that, under a same SiH₄ gas partial pressure, the Si/Ta ratio in the film is lower in the low temperature condition of 400°C than in the standard condition of 600°C. That is, under a same SiH₄ gas partial pressure, as the film forming temperature is increased, the Si/Ta ratio, i.e., si concentration in the film is increased. Under a same SiH₄ gas partial pressure, the Si/Ta ratio, i.e., the Si concentration in the film is increased as the NH₃ gas partial pressure is decreased.

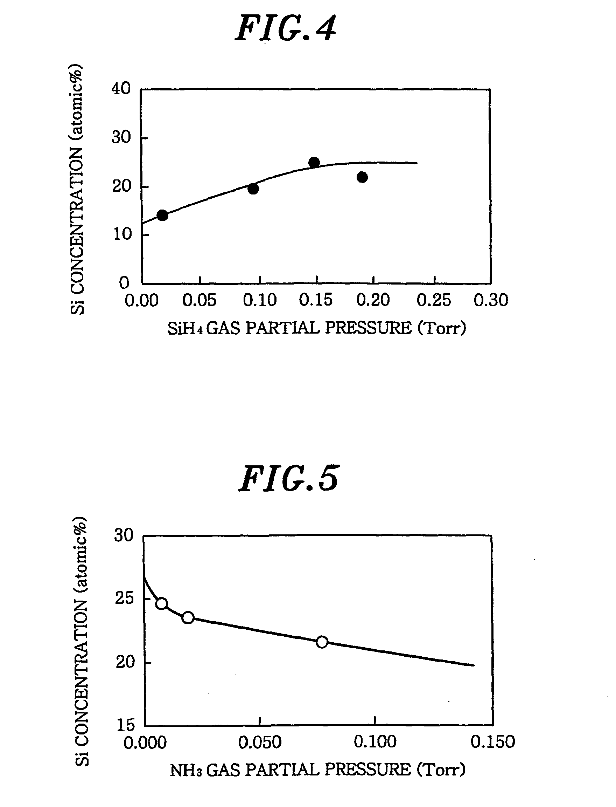

Figs. 4 to 7 show relationships between each of the film forming conditions and Si concentration in the film obtained based on the relationships in Figs. 3 and 2. Fig. 4 shows the relationship between the SiH₄ gas partial pressure and Si concentration in the film and it can be seen that Si concentration in the film tends to increase as the SiH₄ gas partial pressure is increased. When the SiH₄ gas partial pressure is greater than 0.15 Torr (19.9 Pa), Si concentration in the film tends to be saturated. It is expected, however, that a film having a high Si concentration can be formed until the SiH₄ gas partial pressure becomes 0.5 Torr (66.5 Pa). Fig. 5 shows the relationship between the NH₃ gas partial pressure and Si concentration in the film and it can be seen that Si concentration in the film tends to decrease as the NH₃ gas partial pressure is increased. It can be seen from Fig. 5 that a high Si concentration of about 25 atomic% is obtained when the NH₃ gas partial pressure is 0.001 Torr (0.1 Pa), and that the Si concentration is about 22 atomic% when the NH₃ gas partial pressure is 0.075 Torr (10.0 Pa). Further, it is expected that the Si concentration is about 15 atomic% when the NH₃ gas partial pressure is 0.3 Torr (39.9 Pa).

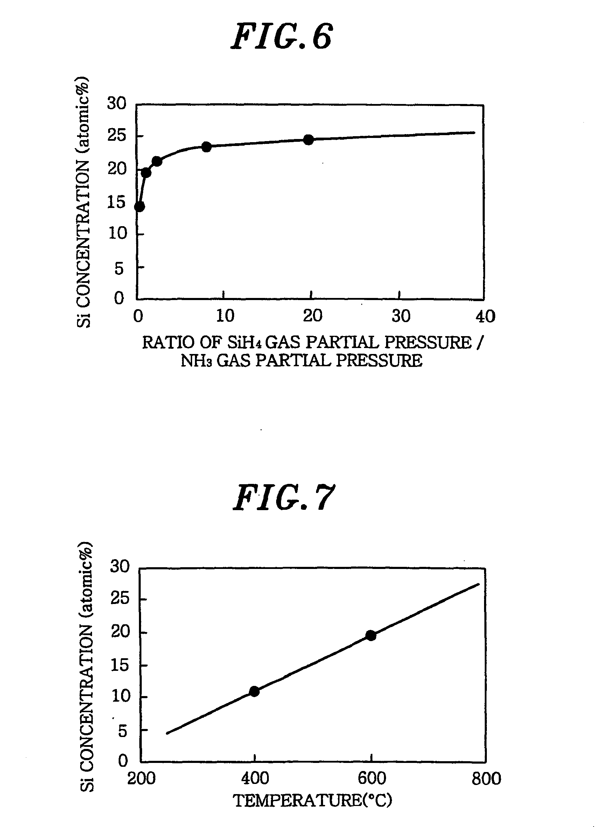

Fig. 6 shows the relationship between a ratio of (SiH₄ gas partial pressure)/(NH₃ gas partial pressure) and Si concentration in the film and it can be seen that Si concentration in the film tends to increase as the ratio of (SiH₄ gas partial pressure)/(NH₃ gas partial pressure) is increased. The Si concentration is sharply increased until the ratio of (SiH₄ gas partial pressure)/(NH₃ gas partial pressure) becomes 2.5. However, if the ratio of (SiH₄ gas partial pressure)/(NH₃ gas partial pressure) is greater than 2.5, the Si concentration is slowly increased as the ratio of (SiH₄ gas partial pressure)/(NH₃ gas partial pressure) is increased. Fig. 7 shows the relationship between the film forming temperature and Si concentration in the film and it can be seen that Si concentration in the film tends to increase as the film forming temperature is increased. In this case, the Si concentration can be controlled when the film forming temperature is in a range of 350 to 700°C.

As described above, in accordance with the present embodiment, parameters for controlling Si concentration in a TaSiN film are found, so that the Si concentration in the TaSiN film can be controlled with high accuracy and a TaSiN film having a high Si concentration can be obtained.

Next, there will be described an application example of a TaSiN film obtained by the film forming method of the present invention to a gate electrode.

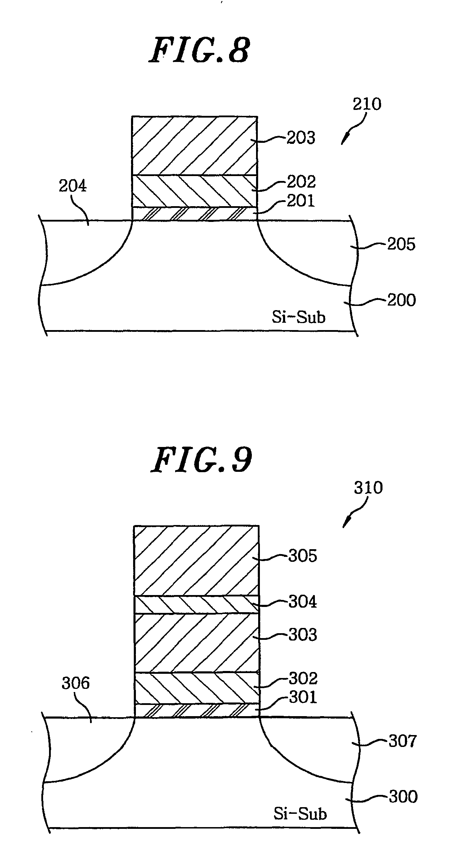

In the example shown in Fig. 8, formed on a Si substrate 200 is a gate insulating film 201 made of HfSiON that is a high-k (high dielectric constant) material. A TaSiN film 202 obtained in accordance with the present invention and a W film 203 are sequentially formed on the gate insulating film 201, so that a gate electrode 210 is formed. A source region 204 and a drain region 205 are formed in the main surface of the Si substrate 200 on both sides of the gate electrode 210. Preferably, the TaSiN film 202 has a film thickness of about 10 to 20 nm. As the high-k (high dielectric constant) material forming the gate insulating film, HfO₂, ZrO₂, ZrSiO, LaO₂, ReO₂, RuO₂ or the like may be used without being limited to the HfSiON.

In the example shown in Fig. 9, formed on a Si substrate 300 is a gate insulating film 301 made of HfO₂ that is a high-k (high dielectric constant) material. A TaSiN film 302 obtained in accordance with the present invention, a W film 303, a WN barrier film 304 and a poly-Si film 305 are sequentially formed on the gate insulating film 201, so that a gate electrode 310 is formed. A source region 306 and a drain region 307 are formed in the main surface of the Si substrate 300 on both sides of the gate electrode 310. Also in this case, the TaSiN film 302 preferably has a film thickness of about 10 to 20 nm. As the high-k (high dielectric constant) material forming the gate insulating film, HfSiON, ZrO₂, ZrSiO, LaO₂, ReO₂, RuO₂ or the like may be used without being limited to the HfO₂.

Although Ta (Nt-Am) (Nme₂)₃ is used as the Ta source material in the above-described embodiment, other organic Ta compounds having Ta=N bond (double bond), e.g., Ta(Nt-Bu)(NEt₂)₃, may be used. Further, the Si-containing gas is not limited to SiH₄ gas, and other gases such as Si₂H₆ may be used. In addition, the N-containing gas is not limited to NH₃ gas, other N-containing gases, such as hydrazine [NH₂NH₂], monomethylhydrazine [(CH₂)HNNH₂] or the like, may be used.

The TaSiN film of the present invention has an appropriate work function, and Si concentration thereof can be controlled, so that the work function can be controlled. Accordingly, it is effective as a gate electrode of MOS semiconductor and it can also be applied as a conventional barrier film without being limited thereto.

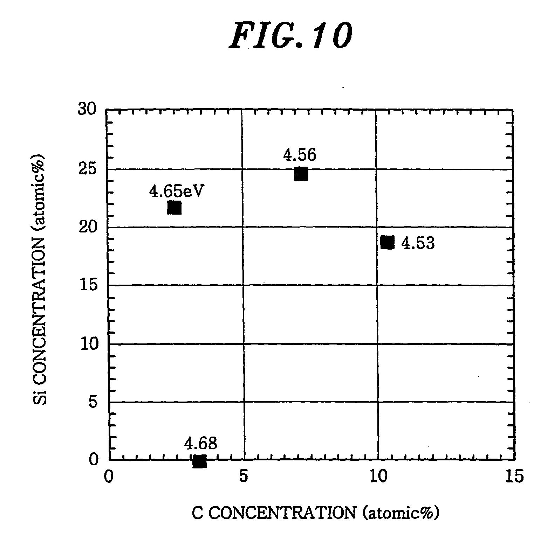

After making a MOS device including a TaSiN film formed in accordance with the film forming method of the present invention, an experiment for evaluating work function of the TaSiN film was performed. The process of the experiment and the results thereof will now be described. A SiO₂ film having a thickness of 0.4 nm was formed, as an interlayer, on a Si substrate. A HfSiON film having a thickness of 3 nm, which contains Si of 60 atomic% and N of 15 atomic%, was formed on the SiO₂ film as a gate oxide film by CVD process, and PNA (post nitridation annealing) process was performed thereon at 700°C. A TaSiN film having a thickness of 20 nm was formed, as an electrode, on the HfSiON film by the following method. In the apparatus shown in Fig. 1, the susceptor 22 was heated to 600°C in advance, and then a 300 mm wafer was mounted on the susceptor 22 by the transfer unit. In this state, four kinds of TaSiN film A to D were formed by varying the flow rate of Ar gas as the carrier gas of an organic Ta compound (C-Ar), the flow rate of Ar gas as the dilution gas (D-Ar), the flow rate of SiH₄ gas (SiH₄), the partial pressure of SiH₄ gas (SiH₄PP), the flow rate of NH₃ gas (NH₃), the partial pressure of NH₃ gas (NH₃PP) and the film forming time as indicated in the following Table 1. Further, the film forming temperature of 600°C and the film forming pressure (total pressure in the chamber) of 40 Pa were applied to each of the TaSiN films A to D. The compositions (Conc.(at%)) of the TaSiN A to D analyzed by XPS are described in Table 1. After formation of the TaSiN film, RTA (rapid thermal annealing) process was performed thereon for 10 seconds under N₂ ambience of 1000°C. Table 1 also indicates flat band voltages (Vfb) obtained by performing CV measurement on MOS structures including the respective TaSiN films A to D formed in accordance with the above-described method and work functions (W/F) calculated based on the flat band voltages. Further, Fig. 10 is a graph showing the relationship between C concentration (atomic%) and Si concentration (atomic%) and the work function. The numeric values described near the plots indicate work function values (unit: eV). From the graph, it can be seen that a desired work function value of 4.6 eV or less can be obtained when C concentration is 5 atomic% or greater while Si concentration is 30 atomic%.

**Table 1**

| ID | C-Ar | D-Ar | SiH₄ | NH₃ | NH₃PP | SiH₄PP | Time | Conc.(at%) | | | | | Vfb | W/F |
|---|---|---|---|---|---|---|---|---|---|---|---|---|---|---|
| | (sccm) | (sccm) | (sccm) | (sccm) | (Torr) | (Torr) | (sec) | Ta | Si | N | C | 0 | (V) | (eV) |
| A | 40 | 42 | 505 | 213 | 0.08 | 0.19 | .380 | 17.9 | 21.8 | 54.5 | 2.5 | 3.2 | -0.28 | 4.65 |
| B | 40 | 334 | 399 | 27 | 0.01 | 0.15 | 350 | 18 | 24.7 | 43 | 7.2 | 7.1 | -0.37 | 4.56 |
| C | 40 | 321 | 425 | 13 | 0.005 | 0.16 | 370 | 9.8 | 20 | 44 | 10.4 | 17.2 | -0.4 | 4.53 |
| D | 40 | 760 | 0 | 0 | 0 | 0 | 400 | 35.3 | 0 | 39.6 | 3.3 | 21.8 | -0.25 | 4.68 |

## Claims

1. A TaSiN film forming method comprising:
disposing a substrate in a processing chamber; and
introducing a gas of an organic Ta compound having Ta=N bond, a Si-containing gas and a N-containing gas into the processing chamber to form a TaSiN film on the substrate by CVD,
wherein Si concentration in the film is controlled by controlling at least one of a partial pressure of the Si-containing gas in the processing chamber, a total pressure in the processing chamber, a film forming temperature and a partial pressure of the N-containing gas in the processing chamber.

2. The method of claim 1, wherein the si-containing gas is SiH₄ gas and the N-containing gas is NH₃ gas.

3. The method of claim 2, wherein the film forming temperature is set to 350 to 700°C, the total pressure in the processing chamber is set to 1.33 to 1333 Pa (0.01 to 10 Torr), the partial pressure of the SiH₄ gas is set to 0.4 to 66.5 Pa (0.003 to 0.5 Torr) or 1% to 80% of the total pressure, the partial pressure of the NH₃ gas is set to 0.1 to 39.9 Pa (0.001 to 0.3 Torr) or 0.3% to 30% of the total pressure.

4. The method of claim 3, wherein a flow rate of the SiH₄ gas is set to 10 to 1000 mL/min (sccm), a flow rate of the NH₃ gas is set to 1000 mL/min (sccm) or less, a flow rate Ar gas as a carrier gas for generating the organic Ta compound gas from the organic Ta compound is set to 10 to 200 mL/min (sccm), a flow rate of Ar gas as a dilution gas is set to 10 to 1000 mL/min (sccm).

5. The method of any one of claims 2 to 4, wherein when the film forming temperature is set to 600°C and the total pressure in the processing chamber is set to 40 Pa (0.3 Torr), the Si concentration in the film is controlled based on a relationship of y = 0.64 × log x + 1.69 where x is the SiH₄ gas partial pressure (Torr) and y is a ratio of (Si atom number)/(Ta atom number) in the film.

6. The method of any one of claims 2 to 4, wherein when the film forming temperature is set to 600°C and the total pressure in the processing chamber is set to 6.7 Pa (0.05 Torr), the Si concentration in the film is controlled based on a relationship of y = 0.46 × log x + 1.58 where x is the SiH₄ gas partial pressure (Torr) and y is a ratio of (Si atom number)/(Ta atom number) in the film.

7. A TaSiN film forming method comprising:
disposing a substrate in a processing chamber; and
introducing a gas of an organic Ta compound having Ta=N bond, SiH₄ gas and NH₃ gas into the processing chamber to form a TaSiN film on the substrate by CVD,
wherein a film forming temperature is set to 600°C or higher, a film forming pressure is set to 20 Pa (0.15 Torr) or greater, a partial pressure of the SiH₄ gas is set to 6.7 Pa (0.05 Torr) or greater or 5% or greater of a total pressure in the processing chamber.

8. The method of claim 7, wherein a partial pressure of the NH₃ gas is set to 13.3 Pa (0.1 Torr) or less or 30% or less of the total pressure in the processing chamber.

9. The method of any one of claims 1 to 8, wherein the Si concentration in the TaSiN film is controlled to be 30 atomic% or less and C concentration in the TaSiN film is controlled to be 5 atomic% or greater.

10. A computer readable storage medium storing therein a control program for controlling a film forming apparatus, wherein when the control program is executed on a computer, the film forming apparatus is controlled by the computer to perform the film forming method described in any one of claims 1 to 9.
